# EUROPEAN PATENT SPECIFICATION

(11) **EP 4 626 146 B1**
(45) Date of publication and mention of the grant of the patent: **22.07.2026**
(21) Application number: 25158770.5
(22) Date of filing: 19.02.2025
(51) Int. Cl.: H02M 7/487, H05K 1/02, H05K 1/185, H10W 70/60

(54) **INVERTER DEVICE**
WECHSELRICHTER
DISPOSITIF ONDULEUR

(30) Priority: 27.03.2024 JP 2024052400
(43) Date of publication of application: 01.10.2025
(73) Proprietor: MAZDA MOTOR CORPORATION, Hiroshima 730-8670 (JP)
(72) Inventor: Furukawa, Akihiro, Aki-gun, Hiroshima 730-8670 (JP); Togashi, Shigenori, Sagamihara, Kanagawa 252-0243 (JP)
(74) Representative: Lorenz Seidler Gossel Part. mbB

(56) References cited:
- WO-A1-2014/202282
- CN-A- 117 716 617
- US-A1- 2019 274 219

## Description

### BACKGROUND

The technology disclosed herein belongs to a technical field related to an inverter device.

As inverter devices are becoming increasingly higher in power output with the improvement in power density, a technology for reducing the inductance of the inverter devices is being required.

Japanese Unexamined Patent Publication No. 2003-259656 describes a technology in which, in an inverter of DC-AC conversion, in order to reduce the interconnect inductance, two interconnect conductors are placed in parallel and close to each other and currents in the opposite directions are passed through the conductors, whereby the interconnect inductance is reduced by the use of the mutual inductance.

CN 117 716 617 A discloses a DC/DC power converter including a plurality of first and second switching cells comprising die packages being embedded in the printed circuit board. Electrical terminals of the die packages are connected with corresponding electric terminals on the printed circuit board to improve power density.

Conventional inverter devices are formed by mounting transistors on a surface of an interconnect substrate. However, in the mounting of transistors on a surface of an interconnect substrate, there arises a problem of failing to sufficiently reduce the self-inductance due to the influence of bonding wires connecting the transistors and the interconnect substrate.

In view of the above problem, an objective of the technology disclosed herein is reducing the inductance of an inverter device.

### SUMMARY

The invention is defined by the subject-matter of claim 1. A preferred embodiment is defined by the subject-matter of claim 2.

Having the above configuration, it is possible to shorten the interconnect between the first power line and the ground line and the interconnect between the second power line and the ground line in the inverter device. This can reduce the inductance of the inverter device. Moreover, since the terminals on the ground-line sides of the first capacitor and the second capacitor can be placed close to each other, the first capacitor and the second capacitor can be put together and placed efficiently. This can achieve downsizing of the inverter device.

As described above, according to the technology disclosed herein, the inductance of the inverter device can be reduced.

### BRIEF DESCRIPTION OF THE DRAWINGS

FIG. 1 is a circuit diagram of an inverter device.
FIG. 2 is a plan view of the inverter device.
FIG. 3 is a plan view of one phase of the inverter device as viewed from above a second interconnect layer.
FIG. 4 is a bottom view of one phase of the inverter device as viewed from below a fifth interconnect layer.
FIG. 5 is a cross-sectional view taken along line V-V in FIG. 3.
FIG. 6 is a cross-sectional view taken along line VI-VI in FIG. 3.
FIG. 7 is view for explaining an area reducing effect of the inverter device according to an embodiment.
FIG. 8 is a view for explaining an effect obtained by giving a common ground line for ground lines for three phases.
FIG. 9 is a view for explaining the effect obtained by giving a common ground line for ground lines for three phases.
FIG. 10 is a sectional side view, equivalent of FIG. 5, showing another configuration example of the inverter device.
FIG. 11 is a sectional side view, equivalent of FIG. 6, showing another configuration example of the inverter device.
FIG. 12 is a plan view of the inverter device.

### DETAILED DESCRIPTION

In the present disclosure, the term "connection" is used as a concept broadly encompassing the state of being electrically connected. For example, the term "connection" includes, not only the case of direct connection between elements, but also the case of indirect connection between elements through a via or the like.

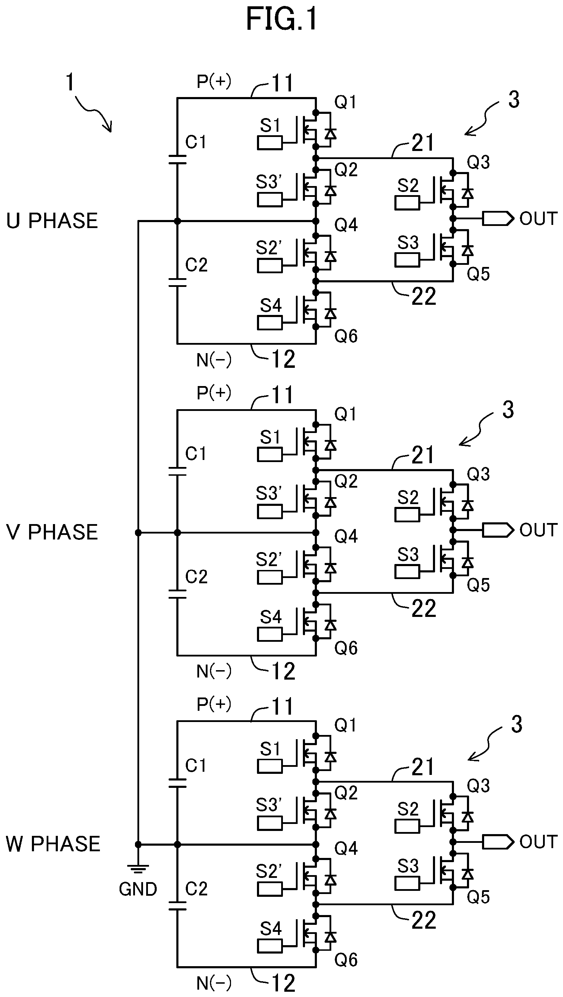

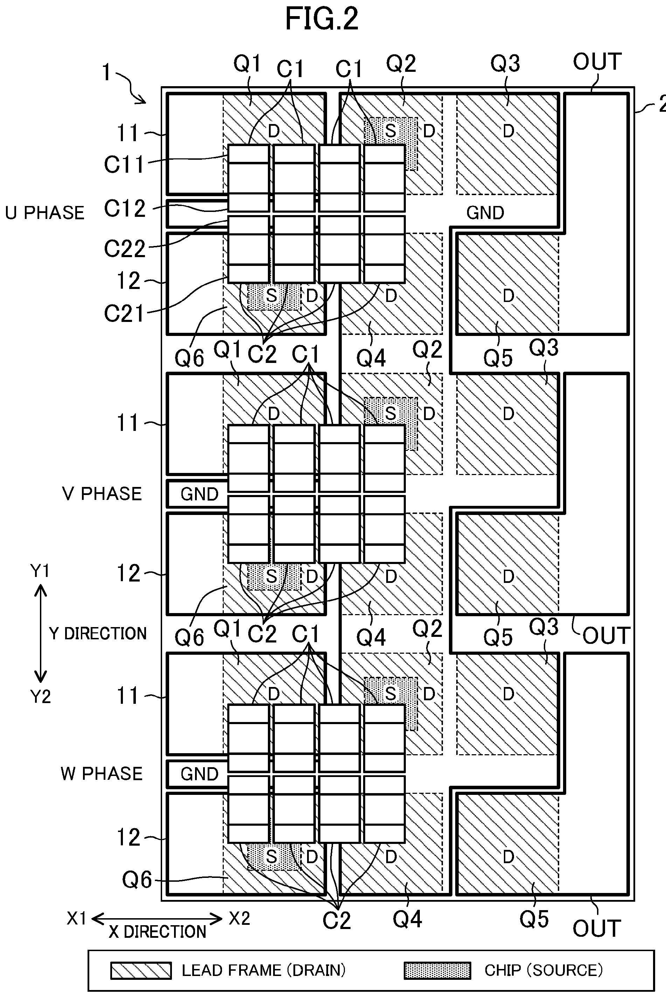

FIG. 1 is a circuit diagram of an inverter device 1 according to the embodiment. FIG. 2 is a plan view of the inverter device 1, showing interconnects in an interconnect layer L2, in which an interconnect layer L1 is omitted.

As shown in FIG. 1, in this example, the inverter device 1 is a 3-level inverter that outputs AC of three phases (U phase, V phase, and W phase) from a DC power supply such as a battery (not shown). The uses of the inverter device 1 are not specifically limited, but include driving of automobiles and actuation of engines (e.g., an integrated starter generator (ISG)), for example.

As shown in FIGS. 1 and 2, the inverter device 1 includes an interconnect substrate 2 and inverter circuits 3 of three phases (U phase, V phase, and W phase) mounted in the interconnect substrate 2. The inverter circuit 3 of each phase includes transistors Q1 to Q6, a first capacitor C1, and a second capacitor C2. Note that, in the following description, the transistors Q1 to Q6 may be collectively called the "transistors Q" when no distinction is made among them.

### -Interconnect Substrate-

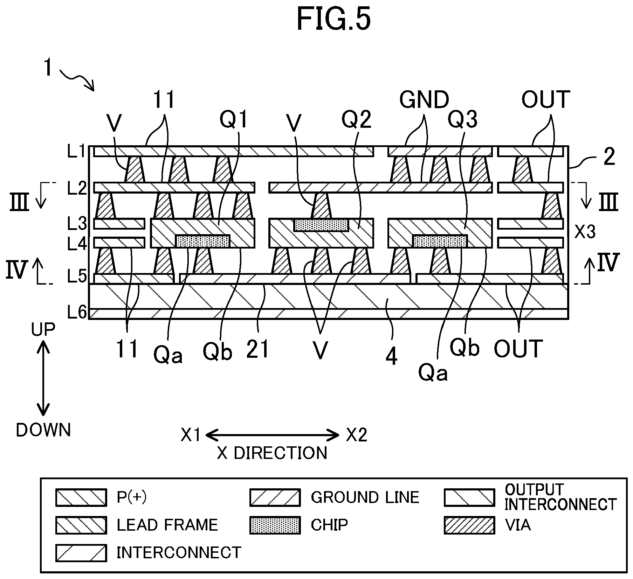

The interconnect substrate 2 is a multi-layer interconnect substrate (e.g., a printed board) having six interconnect layers, for example. For convenience of description, as shown in FIG. 5, the thickness direction of the interconnect substrate 2 is defined as the up/down direction, and the interconnect layer (first interconnect layer) having the principal surface (uppermost face) on which the first capacitor C1 and the second capacitor C2 are placed is called an interconnect layer L1. From the interconnect layer L1 downward, interconnect layers L2 to L6 (second to sixth interconnect layers) are formed in this order with an insulating layer (e.g., a layer formed of resin) interposed between every adjacent interconnect layers. From the standpoint of improving heat dissipation performance, it is preferable to use a glass epoxy resin or a high thermal conductive resin for the insulating layer between the interconnect layer L5 and the interconnect layer L6.

### -Transistor-

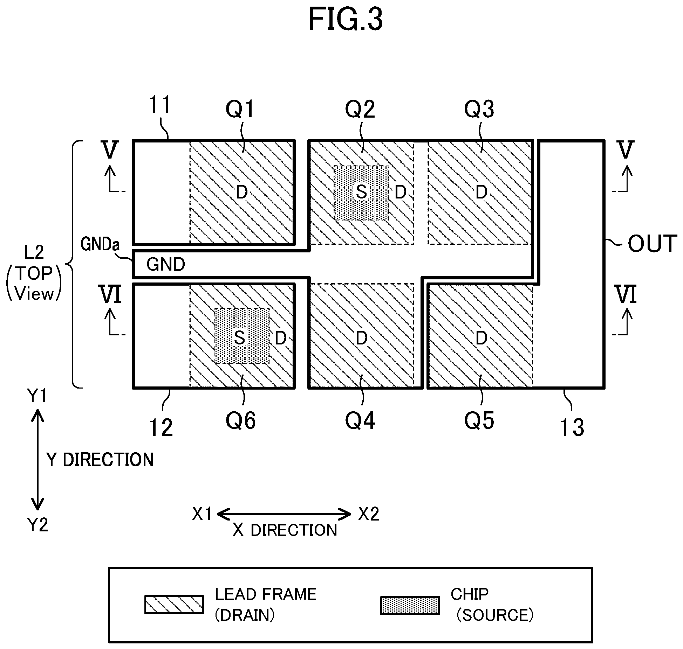

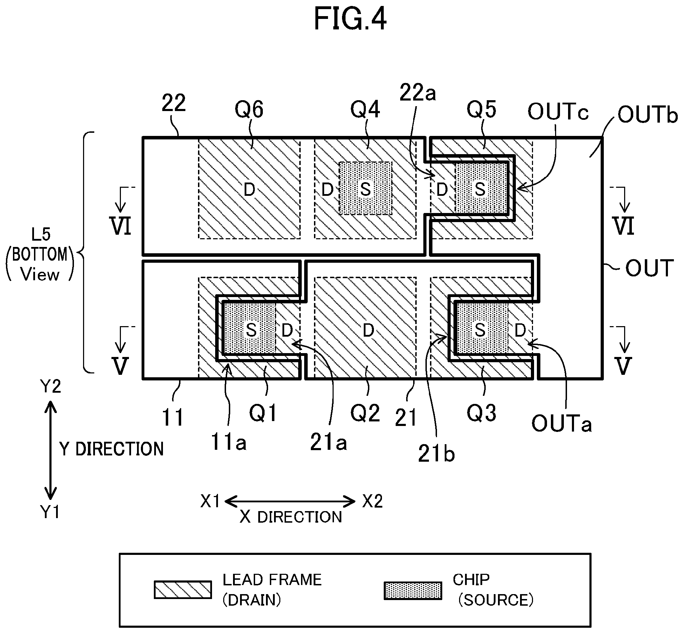

FIG. 3 is a plan view of the inverter device 1 as viewed from above the interconnect layer L2, and FIG. 4 is a bottom view of the inverter device 1 as viewed from below the interconnect layer L5, illustrated for one phase. In FIGS. 3 and 4, the positions of the transistors Q1 to Q6 are indicated by the broken lines. Note that the X direction and the Y direction are defined as directions perpendicular to the up/down direction and also directions orthogonal to each other. Also, in the following description, out of the X direction, the leftward direction in FIG. 3 may be called the X1 direction and the rightward direction in FIG. 3 called the X2 direction. Also, out of the Y direction, the upward direction in FIG. 3 may be called the Y1 direction and the downward direction in FIG. 3 called the Y2 direction.

The transistors Q are each an n-type power MOSFET of a vertical structure, and in this example, constituted by a semiconductor chip Qa (simply indicated as a "chip" in the figures) and a lead frame Qb (see FIG. 5). The semiconductor chip Qa has a source on one face and a drain on the other face. The lead frame Qb, made of copper, for example, is formed to have a U-shape in sectional side view to cover the other face (drain) of the semiconductor chip Qa, and connected to the drain of the semiconductor chip Qa. That is, the lead frame Qb and the drain of the semiconductor chip Qa have the same potential.

In other words, the transistor Q has a source region S in which a source terminal is provided and a drain region D in which a drain terminal is provided to surround the source region S on one face, and has the drain region D on the other face. The "terminal" is used herein to mean an inlet/outlet of a current, and its specific form and mode are not specifically limited.

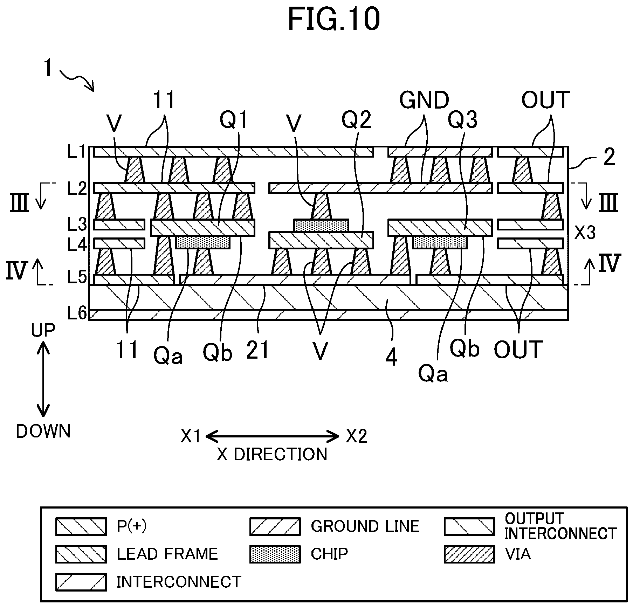

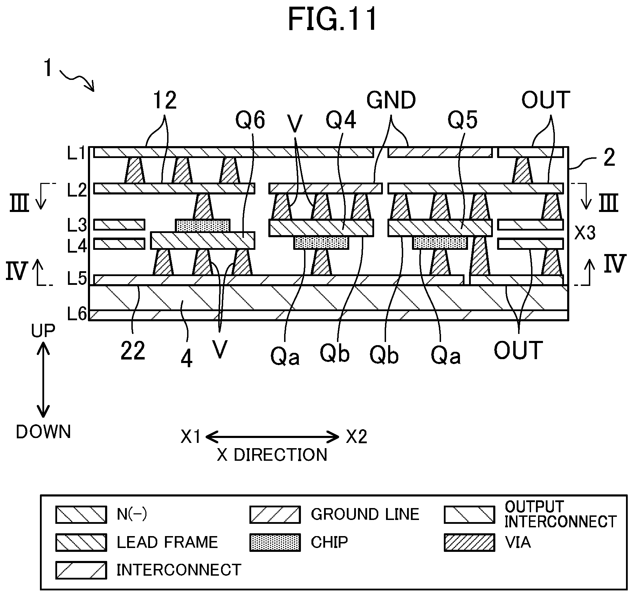

In the following description, the one face is called the "source-drain face" and the other face is called the "drain face." Note that the "one face (source-drain face)" and the "other face (drain face)" as used herein are not limited to be flat faces. Specifically, for example, as will be described with reference to FIGS. 10 and 11 later, there may be a step (vertical step in FIGS. 10 and 11) on the source-drain face between the face on which the source is provided and the face on which the drain is provided. As another example, part of the face on which the source is provided and/or the face on which the drain is provided may be inflated or dented. Note that the gate of the transistor Q is formed on the source-drain face of the semiconductor chip Qa although illustration is omitted because it falls outside the subject matter of the technology disclosed.

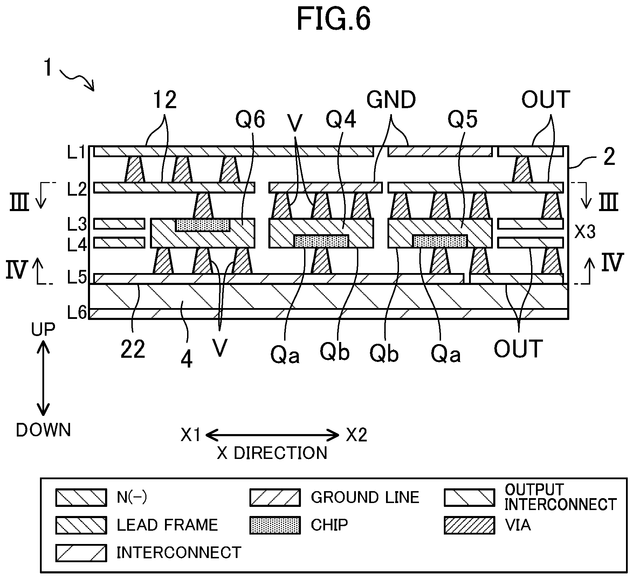

Note that the source and drain of each transistor Q and interconnects formed in the interconnect layers L2 and L5 are connected through a plurality of vias V and the lead frame Qb. For convenience of description, however, description of the connections through the vias V and the lead frame Qb may be omitted hereinafter. This also applies to connections of interconnects between interconnect layers: i.e., illustration may be omitted and description of connections through vias V and lead frames Qb may be omitted. Note also that, in FIGS. 5 and 6, for easy understanding of the drawings, common hatching is given to interconnects to which a common signal or voltage is applied. In other words, in FIGS. 5 and 6, interconnects under common hatching are mutually connected through vias and the like (whether shown or not shown).

The transistors Q1 to Q6 will be described individually hereinafter.

As shown in FIGS. 3 to 6, the transistors Q1 to Q6 of three phases are placed in a middle layer between the interconnect layer L2 and the interconnect layer L5. In this example, the interconnect layer L3, the interconnect layer L4, and an insulating layer X3 between the interconnect layers L3 and L4 correspond to the "middle layer." In other words, the transistors Q1 to Q6 of three phases are embedded in the interconnect substrate 2. As shown in FIG. 3, the transistors Q1 to Q6 of three phases are arranged in order in planar view. Note that, since the configurations of the transistors Q1 to Q6 are the same among U phase, V phase, and W phase, description here will be made for one phase only.

The transistor Q1 (corresponding to the first transistor) is placed with the drain face facing the interconnect layer L2 and the source-drain face facing the interconnect layer L5, that is, positioned with the drain face facing upward. In the transistor Q1, the drain terminal (hereinafter simply called the "drain") on the drain face is connected to a first power line 11 in the interconnect layer L2, and the source terminal (hereinafter simply called the "source") is connected to an interconnect 21 (corresponding to the first interconnect) in the interconnect layer L5.

The transistor Q6 (corresponding to the second transistor), located on the side of the transistor Q1 in the Y2 direction (corresponding to the first direction), is placed with the source-drain face facing the interconnect layer L2 and the drain face facing the interconnect layer L5, that is, positioned with the source-drain face facing upward. In the transistor Q6, the source is connected to a second power line 12 in the interconnect layer L2, and the drain on the drain face is connected to an interconnect 22 (corresponding to the second interconnect) in the interconnect layer L5.

The transistor Q2 (corresponding to the third transistor), located on the side of the transistor Q1 in the X2 direction (corresponding to the second direction), is placed with the source-drain face facing the interconnect layer L2 and the drain face facing the interconnect layer L5, that is, positioned with the source-drain face facing upward. In the transistor Q2, the source is connected to a ground line GND in the interconnect layer L2, and the drain on the drain face is connected to the interconnect 21 in the interconnect layer L5.

The transistor Q4 (corresponding to the fourth transistor), located on the side of the transistor Q2 in the Y2 direction and on the side of the transistor Q6 in the X2 direction, is placed with the drain face facing the interconnect layer L2 and the source-drain face facing the interconnect layer L5, that is, positioned with the drain face facing upward. In the transistor Q4, the source is connected to the interconnect 22 in the interconnect layer L5, and the drain on the drain face is connected to the ground line GND in the interconnect layer L2.

The transistor Q3 (corresponding to the fifth transistor), located on the side of the transistor Q2 in the X2 direction, is placed with the drain face facing the interconnect layer L2 and the source-drain face facing the interconnect layer L5, that is, positioned with the drain face facing upward. In the transistor Q3, the source is connected to an output interconnect OUT in the interconnect layer L5, and the drain on the X1-direction side of the source-drain face is connected to the interconnect 21 in the interconnect layer L5.

The transistor Q5 (corresponding to the sixth transistor), located on the side of the transistor Q3 in the Y2 direction and on the side of the transistor Q4 in the X2 direction, is placed with the drain face facing the interconnect layer L2 and the source-drain face facing the interconnect layer L5, that is, positioned with the drain face facing upward. In the transistor Q5, the source is connected to the interconnect 22 in the interconnect layer L5, the drain on the X2-direction side of the source-drain face is connected to the output interconnect OUT in the interconnect layer L5, and the drain on the drain face is connected to the output interconnect OUT in the interconnect layer L2.

### -Capacitor-

The first capacitor C1 is provided between the first power line 11 to which a positive power supply voltage P(+) is supplied from a battery (not shown) or the like and the ground line GND that is grounded. The second capacitor C2 is provided between the ground line GND and the second power line 12 to which a negative power supply voltage N(-) is supplied from a battery (not shown) or the like.

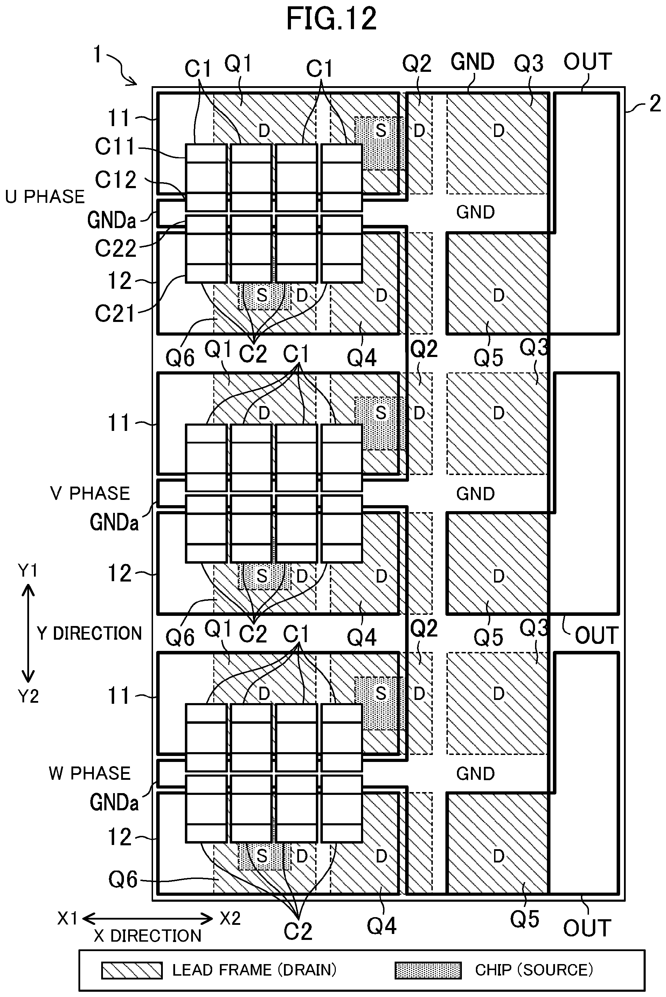

Specifically, the first capacitor C1 and the second capacitor C2 are mounted on the surface of the interconnect layer L1. As shown in FIG. 12, in the interconnect layer L1, the ground line GND is placed between the first power line 11 provided at the position overlapping the transistor Q1 and the second power line 12 provided at the position overlapping the transistor Q6 in planar view. Note that, although FIG. 12 shows an example in which the first power line 11 is provided to cover the entire of the transistor Q1, that is, to overlap the entire of the transistor Q1 in planar view, the configuration is not limited to this. For example, the first power line 11 may be provided to cover part of the transistor Q1. Specifically, the position of the end of the first power line 11 in the Y1 direction may be located inward of the end of the transistor Q1 in the Y2 direction in planar view. This also applies to the relationship between the second power line 12 and the transistor Q6.

The first capacitor C1 is placed so that a terminal C11 (corresponding to the one terminal) overlaps the first power line 11 and a terminal C12 (corresponding to the other terminal) overlaps the ground line GND in planar view. In the interconnect layer L1, the terminal C11 and the first power line 11 are mutually connected, and the terminal C12 and the ground line GND are mutually connected. The second capacitor C2 is placed so that a terminal C21 (corresponding to the one terminal) overlaps the second power line 12 and a terminal C22 (corresponding to the other terminal) overlaps the ground line GND in planar view. In the interconnect layer L1, the terminal C21 and the second power line 12 are mutually connected, and the terminal C22 and the ground line GND are mutually connected.

Moreover, in this embodiment, as shown in FIG. 12, in the interconnect layer L1, the first power line 11 extends from the position overlapping the transistor Q1 to a position overlapping the transistor Q2 in the X2 direction, and the second power line 12 extends from the position overlapping the transistor Q6 to a position overlapping the transistor Q4 in the X2 direction. Also, in the interconnect layer L1, the ground line GND extends in the X2 direction to the space between the first power line 11 provided at the position overlapping the transistor Q2 and the second power line 12 provided at the position overlapping the transistor Q4. Part of the first capacitor C1 is placed so that the terminal C11 overlaps the first power line 11 at the position overlapping the transistor Q2 and the terminal C12 overlaps the ground line GND provided in the Y2 direction with respect to the transistor Q2 in planar view, and these terminals and the lines are respectively connected. Similarly, part of the second capacitor C2 is placed so that the terminal C21 overlaps the second power line 12 at the position overlapping the transistor Q4 and the terminal C22 overlaps the ground line GND provided in the Y1 direction with respect to the transistor Q4 in planar view, and these terminals and the lines are respectively connected. Note that, when the space for placing the first capacitor C1 and the second capacitor C2 is sufficiently secured, it is unnecessary to provide the first capacitor C1 at the position overlapping the transistor Q2 and also unnecessary to provide the second capacitor C2 at the position overlapping the transistor Q4.

### -Interconnect-

As shown in FIG. 12, the first power line 11 in the interconnect layer L1 is located to cover part or the entire of the transistor Q1 in planar view, and the first power line 11 is connected to the terminal C11 (see FIG. 2) of the first capacitor C1 in the interconnect layer L1. Also, the first power line 11 in the interconnect layer L2 is connected to the drain of the transistor Q1. That is, the first power line 11 is an interconnect formed in the interconnect layer L1 and the interconnect layer L2. Moreover, the first power line 11 in the interconnect layer L2 is connected to the first power line 11 in the interconnect layer L5 through vias and the like (not shown). The first power line 11 in the interconnect layer L5 is connected to the drain on the source-drain face of the transistor Q1. Specifically, as shown in the plan view of FIG. 4, the first power line 11 is connected to the drain of the transistor Q1 in a C-shaped region in which the first power line 11 and the drain region D of the transistor Q1 overlap each other. In other words, the first power line 11 overlaps the drain region D on the source-drain face of the transistor Q1 in a C-shape and has a recess 11a recessed in a rectangular shape from the opening of the C-shape to the source region S of the transistor Q1 in the X1 direction, in planar view.

The interconnect 21 is an interconnect formed in the interconnect layer L5, and extends from the source region S of the transistor Q1 to the drain region D of the transistor Q3, for example. The interconnect 21 connects the source of the transistor Q1, the drain of the transistor Q2, and the drain of the transistor Q3 to one another. As shown in FIG. 4, the interconnect 21 has a protrusion 21a protruding to the recess 11a of the first power line 11 in the X1 direction and overlapping the source region S of the transistor Q1 in planar view. At the position of the overlap of the protrusion 21a with the source region S of the transistor Q1, the interconnect 21 is connected to the source of the transistor Q1. Also, the interconnect 21 overlaps the drain region D on the source-drain face of the transistor Q3 in a C-shape and has a recess 21b recessed in a rectangular shape from the opening of the C-shape to the source region S of the transistor Q3 in the X1 direction in planar view.

The output interconnect OUT is an interconnect formed in the interconnect layer L5, and connects the source of the transistor Q3 and the drain of the transistor Q5 to each other. The power of each phase of the inverter device 1 is output from the output interconnect OUT. Specifically, the output interconnect OUT includes: a protrusion OUTa that protrudes into the recess 21b of the interconnect 21 in the X1 direction and overlaps the source region S of the transistor Q3; and a rectangular interconnect OUTb that is integrally and continuously formed with the protrusion OUTa and extends in the Y direction, in planar view. Further, the output interconnect OUT extends from the interconnect OUTb in the X1 direction, overlaps the drain region D on the source-drain face of the transistor Q5 in a C-shape, and has a recess OUTc recessed in a rectangular shape from the opening of the C-shape to the source region S of the transistor Q5 in the X2 direction, in planar view.

The interconnect 22 is an interconnect formed in the interconnect layer L5, and extends from the source region S of the transistor Q5 to a position beyond the end of the transistor Q6 in the X1 direction, for example. The interconnect 22 connects the source of the transistor Q5, the source of the transistor Q4, and the drain of the transistor Q6 to one another. The interconnect 22 has a protrusion 22a protruding into the recess OUTc of the output interconnect OUT in the X2 direction and overlapping the source region S of the transistor Q5 in planar view. At the position of the overlap of the protrusion 22a with the source region S of the transistor Q5, the interconnect 22 is connected to the source of the transistor Q5.

As shown in FIG. 12, the ground line GND in the interconnect layer L1 is positioned between the first power line 11 and the second power line 12 in planar view. In the example of FIG. 12, the ground line GND has a protrusion GNDa protruding to the space between the first power line 11 and the second power line 12 in planar view. It is this protrusion GNDa that is placed between the first power line 11 and the second power line 12 in planar view. To state differently, in the interconnect layer L1, the ground line GND is laid between the first power line 11 provided at the position overlapping the transistor Q1 and the second power line 12 provided at the position overlapping the transistor Q6 in planar view.

The ground line GND is connected to the terminal C12 (see FIG. 2) of the first capacitor C1 and the terminal C22 (see FIG. 2) of the second capacitor C2 in the interconnect layer L1. Also, as described above, the ground line GND in the interconnect layer L2 is connected to the source of the transistor Q2 and the drain of the transistor Q4. Moreover, as shown in FIG. 2, the ground lines GND of the inverter circuits 3 of three phases are mutually connected through a common ground line GND (corresponding to the common ground line) extending in the Y direction over the three phases. Note that, although FIG. 2 illustrates the configuration in the interconnect layer L2, a common ground line GND extending in the Y direction over the three phases may also be provided in the interconnect layer L1. For example, the common ground line may be provided to extend in the Y direction overlapping the transistor Q3 and the transistor Q5. That is, the ground lines GND in the interconnect layer L1 in FIGS. 5 and 6 may be mutually connected and extend over the inverter circuits 3 of three phases.

As shown in FIG. 12, the second power line 12 in the interconnect layer L1 is located to cover part or the entire of the transistor Q6 in planar view, and the second power line 12 is connected to the terminal C21 (see FIG. 2) of the second capacitor C2 in the interconnect layer L1. Also, as described above, the second power line 12 in the interconnect layer L2 is connected to the source of the transistor Q6. That is, the second power line 12 is formed in the interconnect layer L1 and the interconnect layer L2.

### -Effects of Embodiment-

As described above, the inverter device 1 of this embodiment includes the interconnect substrate 2 having the interconnect layer L1 formed on the surface, a plurality of transistors Q embedded in the interconnect substrate 2, the first capacitor C1, and the second capacitor C2. The interconnect layer L1 has the first power line 11, the second power line 12, and the ground line GND. The first capacitor C1 is provided between the first power line 11 and the ground line GND in the interconnect layer L1. The second capacitor C2 is provided between the ground line GND and the second power line 12 in the interconnect layer L1. The plurality of transistors Q include the transistors Q1 to Q6. In the transistor Q1, the drain is connected to the first power line 11 and the source is connected to the interconnect 21. In the transistor Q6, placed on the side of the transistor Q1 in the Y2 direction, the drain is connected to the interconnect 22 and the source is connected to the second power line 12. In the interconnect layer L1, the protrusion GNDa of the ground line GND is provided between the first power line 11 provided the a position overlapping the transistor Q1 and the second power line 12 provided at the position overlapping the transistor Q6 in planar view. In other words, in the inverter device 1 of this embodiment, in planar view, (1) the transistor Q1 and the transistor Q6 are placed side by side, (2) the first power line 11 is located to overlap part or the entire of the transistor Q1, (3) the second power line 12 is located to overlap part or the entire of the transistor Q6, (4) the ground line GND is located between the first power line 11 and the second power line 12, (5) the first capacitor C1 is located so that the terminal C11 overlaps the first power line 11 and the terminal C12 overlaps the ground line GND, and (6) the second capacitor C2 is located so that the terminal C21 overlaps the second power line 12 and the terminal C22 overlaps the ground line GND.

With the above configuration, it is possible to shorten the interconnect between the first power line 11 and the ground line GND and the interconnect between the second power line 12 and the ground line GND in the inverter device 1. In this way, the inductance of the inverter device 1 can be reduced.

In the transistor Q2, placed on the side of the transistor Q1 in the X2 direction, the drain is connected to the interconnect 21 and the source is connected to the ground line GND. In the transistor Q4, placed on the side of the transistor Q6 in the X2 direction and on the side of the transistor Q2 in the Y2 direction, the drain is connected to the ground line GND and the source is connected to the interconnect 22. In other words, the transistor Q2 and the transistor Q4 are placed side by side in the Y direction. The transistor Q2 is placed on the side of the transistor Q1 in the X2 direction, and the transistor Q4 is placed on the side of the transistor Q6 in the X2 direction.

In the transistor Q3, placed on the side of the transistor Q2 in the X2 direction, the drain is connected to the interconnect 21 and the source is connected to the output interconnect OUT. In the transistor Q5, placed on the side of the transistor Q4 in the X2 direction and on the side of the transistor Q3 in the Y2 direction, the drain is connected to the output interconnect OUT and the source is connected to the interconnect 22. In other words, the transistor Q3 and the transistor Q5 are placed side by side in the Y direction. The transistor Q3 is placed on the side of the transistor Q2 in the X2 direction, and the transistor Q5 is placed on the side of the transistor Q4 in the X2 direction.

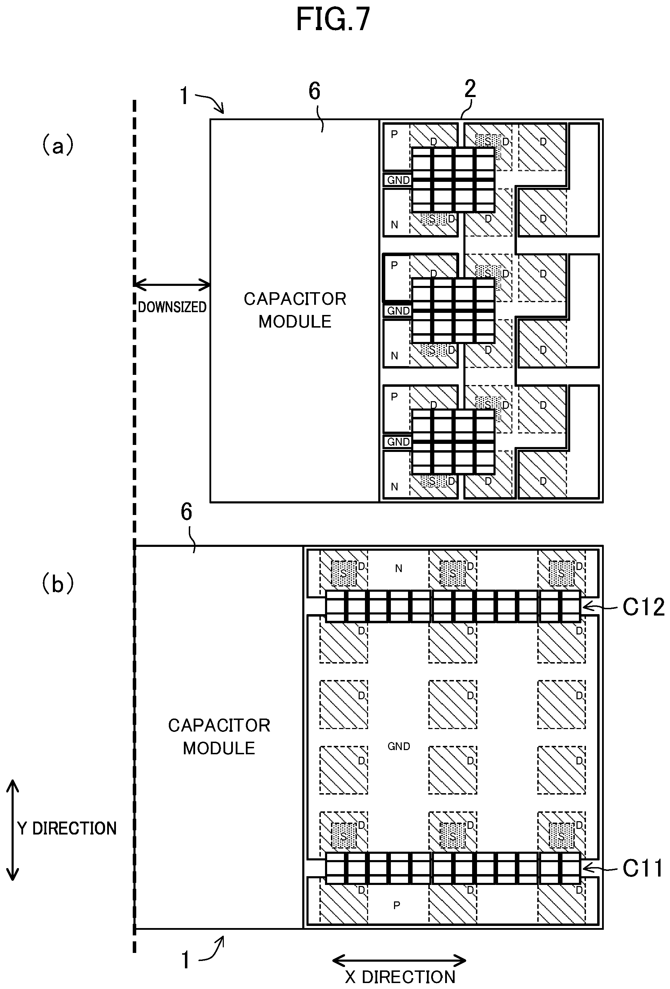

According to the configuration of this embodiment, downsizing of the inverter device 1 can be achieved. This will be described with reference to the relevant drawings. FIG. 7 (a) shows a module configuration of the inverter device 1 of this embodiment, and FIG. 7 (b) shows a module configuration (comparative example) of an inverter device in which the transistors Q1 to Q6 for each phase are arranged linearly. In FIG. 7 (a) and (b), a capacitor module 6 of the same size and the interconnect substrate 2 are placed side by side. The capacitor module 6 is used for stabilizing the DC voltage.

As shown in FIG. 7 (a), in the configuration of this embodiment, since the terminals on the ground-line sides of the first capacitor C1 and the second capacitor C2 (the terminal C12 and the terminal C22) can be placed close to each other, the first capacitor C1 and the second capacitor C2 can be put together and placed efficiently. This permits downsizing of the interconnect substrate 2, and in turn can achieve downsizing of the inverter device 1.

Moreover, in this embodiment, as shown in FIG. 2, the inverter circuits 3 of three phases (U phase, V phase, and W phase), each including the transistors Q1 to Q6, the first capacitor C1, and the second capacitor C2, are arranged in the Y direction in the interconnect substrate 2. The ground lines GND of the inverter circuits 3 of three phases are mutually connected through the common ground line GND extending in the Y direction over the three phases.

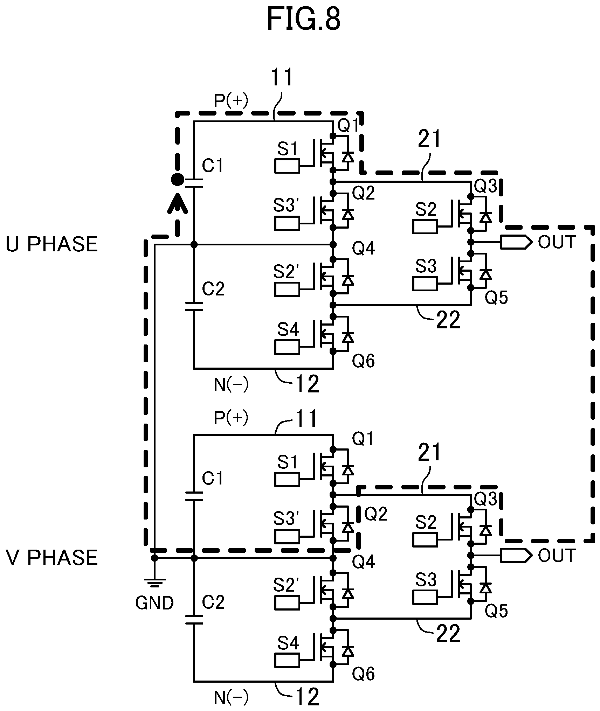

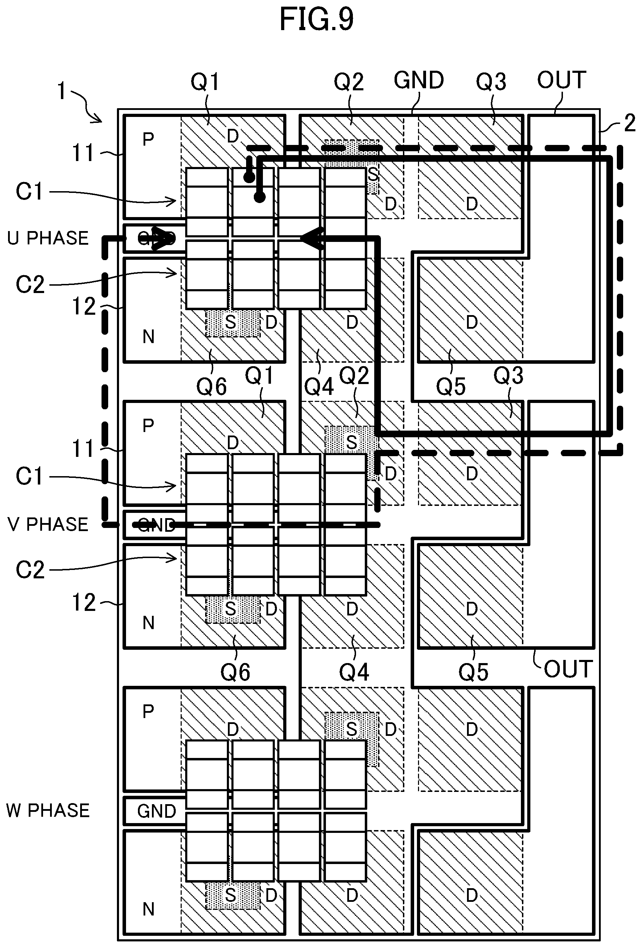

Having the configuration described above, since a current route through the common ground line is formed between U phase and V phase, the inductance of the inverter device 1 can be reduced. This will be described with reference to FIGS. 8 and 9.

In U phase and V phase, a current may flow through the route indicated by the dashed-line arrow in the circuit diagram of FIG. 8 under certain conditions in some cases. In such cases, if the ground line GND for U phase and the ground line GND for V phase are not connected through the common ground line GND, the current will flow through the route indicated by the dashed line in FIG. 9. By contrast, by mutually connecting the ground lines GND for U phase and V phase through the common ground line GND, the current flows through the route indicated by the solid line in FIG. 9. This shortens the current route and thus can reduce the inductance of the inverter device 1. This also applies to the other combinations of the phases.

### <Other Embodiments>

As described above, the above embodiment is a mere illustration of the present disclosure and should not be construed to limit the scope of the present invention.

The scope of the present invention is defined by the appended claims.

For example, the technology of the present disclosure is also applicable to inverter devices having circuit configurations other than that shown in FIG. 1. In an illustrative example not belonging to the claimed invention, the transistor Q2 and the transistor Q4 may be replaced with diodes (not shown).

In the above case, a diode (first diode) replacing the transistor Q2 has a cathode connected to the interconnect 21 in the interconnect layer L5 and an anode connected to the ground line GND in the interconnect layer L2. Similarly, a diode (second diode) replacing the transistor Q4 has a cathode connected to the ground line GND in the interconnect layer L2 and an anode connected to the interconnect 22 in the interconnect layer L5.

In the above configuration using the first diode and the second diode, also, effects similar to those in the above embodiment can be obtained. Specifically, it is possible to shorten the interconnect between the first power line 11 and the ground line GND and the interconnect between the second power line 12 and the ground line GND in the inverter device 1. With this, the inductance of the inverter device 1 can be reduced. Also, since the terminals on the ground-line sides of the first capacitor C1 and the second capacitor C2 (the terminal C12 and the terminal C22) can be placed close to each other, the first capacitor C1 and the second capacitor C2 can be put together and placed efficiently. This permits downsizing of the interconnect substrate 2, and in turn can achieve downsizing of the inverter device 1.

Also, while the transistors Q each include the lead frame Qb having a U-shape in sectional side view as shown in FIGS. 5 and 6 in the above embodiment, the shape is not limited to this. For example, as shown in FIGS. 10 and 11, the lead frame Qb may have a rectangular shape longer on both sides in the X direction than the semiconductor chip Qa in sectional side view. In this case, the width in the Y direction may be made larger on both sides in the Y direction than that of the semiconductor chip Qa as in the above embodiment, or may be the same as that of the semiconductor chip Qa.

In the configuration of FIG. 10, also, the drain (lead frame Qb) on the source-drain face of the transistor Q3 and the interconnect 21 in the interconnect layer L5 are connected through a via V, for example. Similarly, in the configuration of FIG. 11, the drain (lead frame Qb) on the source-drain face of the transistor Q5 and the output interconnect OUT in the interconnect layer L5 are connected through a via V. The other configurations are similar to those in FIGS. 5 and 6. In the configurations of FIGS. 10 and 11, also, effects similar to those in the above embodiment are obtained. That is, the inductance of the inverter device 1 can be reduced, and also downsizing of the inverter device 1 can be achieved.

The technology disclosed herein is very useful because the self-inductance of an inverter device can be reduced.

## Claims

1. An inverter device (1), comprising:
an interconnect substrate (2) with a first interconnect layer (L1) formed on a surface, the first interconnect layer (L1) having a first power line (11), a second power line (12), and a ground line (GND);
a first capacitor (C1) connected to the first power line (11) at one terminal (C11) and to the ground line (GND) at the other terminal (C12);
a second capacitor (C2) connected to the second power line (12) at one terminal (C21) and to the ground line (GND) at the other terminal (C22); and
a plurality of transistors (Q1-Q6) embedded in the interconnect substrate (2) and forming a three-level inverter circuit, wherein
each of the plurality of transistors (Q1-Q6) has a source region (S) in which a source terminal is provided and a drain region (D) in which a drain terminal is provided to surround the source region (S) on one face, and has the drain region (D) on the other face,
the plurality of transistors include
a first transistor (Q1) having a drain (D) connected to the first power line (11) and a source (S) connected to a first interconnect (21),
a second transistor (Q6) placed on the side of the first transistor (Q1) in a first direction (Y), the second transistor (Q6) having a source (S) connected to the second power line (12) and a drain (D) connected to a second interconnect (22),
a third transistor (Q2) placed on the side of the first transistor (Q1) in a second direction (X) orthogonal to a thickness direction of the interconnect substrate (2) and
to the first direction (Y), the third transistor (Q2) having a drain (D) connected to the first interconnect (21) and a source (S) connected to the ground line (GND),
a fourth transistor (Q4) placed on the side of the second transistor (Q6) in the second direction (X) and on the side of the third transistor (Q2) in the first direction (Y), the fourth transistor (Q4) having a drain (D) connected to the ground line (GND) and a source (S) connected to the second interconnect (22),
a fifth transistor (Q3) placed on the side of the third transistor (Q2) in the second direction (X), the fifth transistor (Q3) having a drain (D) connected to the first interconnect (21) and a source (S) connected to an output interconnect (OUT), and a sixth transistor (Q5) placed on the side of the fifth transistor (Q3) in the first direction (Y) and on the side of the fourth transistor (Q4) in the second direction (X), the sixth transistor (Q5) having a drain (D) connected to the output interconnect (OUT) and a source (S) connected to the second interconnect (22), and
in planar view,
the ground line (GND) is placed between the first power line (11) and the second power line (12),
the first capacitor (C1) is placed so that the one terminal (C11) overlaps the first power line (11) and the other terminal (C12) overlaps the ground line (GND), and
the second capacitor (C2) is placed so that the one terminal (C21) overlaps the second power line (12) and the other terminal (C22) overlaps the ground line (GND).

2. The inverter device (1) of claim 1, wherein
in the interconnect substrate (2), inverter circuits (3) of three phases each including the plurality of transistors (Q1-Q6), the first capacitor (C1), and the second capacitor (C2) are arranged in the first direction (Y), and
a common ground line (GND) extending in the first direction (Y) is placed over the inverter circuits (3) of three phases, and the ground lines (GND) in the inverter circuits (3) of three phases are mutually connected through the common ground line (GND).

## Patentansprüche

1. Wechselrichtervorrichtung (1), umfassend:
ein Verdrahtungssubstrat (2) mit einer ersten Verdrahtungsschicht (L1), die auf einer Oberfläche ausgebildet ist, wobei die erste Verdrahtungsschicht (L1) eine erste Leistungsleitung (11), eine zweite Leistungsleitung (12) und eine Masseleitung (GND) aufweist;
einen ersten Kondensator (C1), der an einem Anschluss (C11) mit der ersten Leistungsleitung (11) und am anderen Anschluss (C12) mit der Masseleitung (GND) verbunden ist;
einen zweiten Kondensator (C2), der an einem Anschluss (C21) mit der zweiten Leistungsleitung (12) und am anderen Anschluss (C22) mit der Masseleitung (GND) verbunden ist; und
eine Mehrzahl von Transistoren (Q1-Q6), die in das Verdrahtungssubstrat (2) eingebettet sind und eine Drei-Pegel-Wechselrichterschaltung bilden, wobei jeder der Mehrzahl von Transistoren (Q1-Q6) einen Source-Bereich (S), in dem ein Source-Anschluss vorgesehen ist, und einen Drain-Bereich (D), in dem ein Drain-Anschluss vorgesehen ist, aufweist, um den Source-Bereich (S) auf einer Fläche zu umgeben, und den Drain-Bereich (D) auf der anderen Fläche aufweist,
die Mehrzahl von Transistoren umfasst:
einen ersten Transistor (Q1) mit einem Drain (D), der mit der ersten Leistungsleitung (11) verbunden ist, und einer Source (S), die mit einer ersten Verbindungsleitung (21) verbunden ist,
einen zweiten Transistor (Q6), der auf der Seite des ersten Transistors (Q1) in einer ersten Richtung (Y) angeordnet ist, wobei der zweite Transistor (Q6) eine Source (S), die mit der zweiten Leistungsleitung (12) verbunden ist, und einen Drain (D), der mit einer zweiten Verbindungsleitung (22) verbunden ist, aufweist, einen dritten Transistor (Q2), der auf der Seite des ersten Transistors (Q1) in einer zweiten Richtung (X) angeordnet ist, die orthogonal zu einer Dickenrichtung des Verdrahtungssubstrats (2) und zu der ersten Richtung (Y) ist, wobei der dritte Transistor (Q2) einen Drain (D), der mit der ersten Verbindungsleitung (21) verbunden ist, und eine Source (S), die mit der Masseleitung (GND) verbunden ist, aufweist,
einen vierten Transistor (Q4), der auf der Seite des zweiten Transistors (Q6) in der zweiten Richtung (X) und auf der Seite des dritten Transistors (Q2) in der ersten Richtung (Y) angeordnet ist, wobei der vierte Transistor (Q4) einen Drain (D), der mit der Masseleitung (GND) verbunden ist, und eine Source (S), die mit der zweiten Verbindungsleitung (22) verbunden ist, aufweist,
einen fünften Transistor (Q3), der auf der Seite des dritten Transistors (Q2) in der zweiten Richtung (X) angeordnet ist, wobei der fünfte Transistor (Q3) einen Drain (D), der mit der ersten Verbindungsleitung (21) verbunden ist, und eine Source (S), die mit einer Ausgangsverbindungsleitung (OUT) verbunden ist, aufweist, und
einen sechsten Transistor (Q5), der auf der Seite des fünften Transistors (Q3) in der ersten Richtung (Y) und auf der Seite des vierten Transistors (Q4) in der zweiten Richtung (X) angeordnet ist, wobei der sechste Transistor (Q5) einen Drain (D), der mit der Ausgangsverbindungsleitung (OUT) verbunden ist, und eine Source (S), die mit der zweiten Verbindungsleitung (22) verbunden ist, aufweist, und
in Draufsicht
die Masseleitung (GND) zwischen der ersten Leistungsleitung (11) und der zweiten Leistungsleitung (12) angeordnet ist,
der erste Kondensator (C1) so angeordnet ist, dass der eine Anschluss (C11) die erste Leistungsleitung (11) überlappt und der andere Anschluss (C12) die Masseleitung (GND) überlappt, und der zweite Kondensator (C2) so angeordnet ist, dass der eine Anschluss (C21) die zweite Leistungsleitung (12) überlappt und der andere Anschluss (C22) die Masseleitung (GND) überlappt.

2. Wechselrichtervorrichtung (1) nach Anspruch 1, wobei
in dem Verdrahtungssubstrat (2) Wechselrichterschaltungen (3) von drei Phasen, die jeweils die Mehrzahl von Transistoren (Q1-Q6), den ersten Kondensator (C1) und den zweiten Kondensator (C2) umfassen, in der ersten Richtung (Y) angeordnet sind, und
eine gemeinsame Masseleitung (GND), die sich in der ersten Richtung (Y) erstreckt, über den Wechselrichterschaltungen (3) von drei Phasen angeordnet ist, und die Masseleitungen (GND) in den Wechselrichterschaltungen (3) von drei Phasen durch die gemeinsame Masseleitung (GND) miteinander verbunden sind.

## Revendications

1. Dispositif onduleur (1), comprenant :
un substrat d'interconnexion (2) comportant une première couche d'interconnexion (L1) formée sur une surface, la première couche d'interconnexion (L1) comportant une première ligne d'alimentation (11), une deuxième ligne d'alimentation (12) et une ligne de masse (GND) ;
un premier condensateur (C1) connecté à la première ligne d'alimentation (11) au niveau d'une borne (C11) et à la ligne de masse (GND) au niveau de l'autre borne (C12) ;
un deuxième condensateur (C2) connecté à la deuxième ligne d'alimentation (12) au niveau d'une borne (C21) et à la ligne de masse (GND) au niveau de l'autre borne (C22) ; et
une pluralité de transistors (Q1-Q6) incorporés dans le substrat d'interconnexion (2) et formant un circuit onduleur à trois niveaux, dans lequel chacun de la pluralité de transistors (Q1-Q6) comporte une région de source (S) dans laquelle une borne de source est prévue et une région de drain (D) dans laquelle une borne de drain est prévue de manière à entourer la région de source (S) sur une face, et comporte la région de drain (D) sur l'autre face,
la pluralité de transistors comprend
un premier transistor (Q1) ayant un drain (D) connecté à la première ligne d'alimentation (11) et une source (S) connectée à une première interconnexion (21),
un deuxième transistor (Q6) disposé du côté du premier transistor (Q1) dans une première direction (Y), le deuxième transistor (Q6) ayant une source (S) connectée à la deuxième ligne d'alimentation (12) et un drain (D) connecté à une deuxième interconnexion (22),
un troisième transistor (Q2) disposé du côté du premier transistor (Q1) dans une deuxième direction (X) orthogonale à une direction d'épaisseur du substrat d'interconnexion (2) et à la première direction (Y), le troisième transistor (Q2) ayant un drain (D) connecté à la première interconnexion (21) et une source (S) connectée à la ligne de masse (GND),
un quatrième transistor (Q4) disposé du côté du deuxième transistor (Q6) dans la deuxième direction (X) et du côté du troisième transistor (Q2) dans la première direction (Y), le quatrième transistor (Q4) ayant un drain (D) connecté à la ligne de masse (GND) et une source (S) connectée à la deuxième interconnexion (22),
un cinquième transistor (Q3) disposé du côté du troisième transistor (Q2) dans la deuxième direction (X), le cinquième transistor (Q3) ayant un drain (D) connecté à la première interconnexion (21) et une source (S) connectée à une interconnexion de sortie (OUT), et
un sixième transistor (Q5) disposé du côté du cinquième transistor (Q3) dans la première direction (Y) et du côté du quatrième transistor (Q4) dans la deuxième direction (X), le sixième transistor (Q5) ayant un drain (D) connecté à l'interconnexion de sortie (OUT) et une source (S) connectée à la deuxième interconnexion (22), et
en vue en plan,
la ligne de masse (GND) est disposée entre la première ligne d'alimentation (11) et la deuxième ligne d'alimentation (12),
le premier condensateur (C1) est disposé de sorte que ladite borne (C11) chevauche la première ligne d'alimentation (11) et que l'autre borne (C12) chevauche la ligne de masse (GND), et le deuxième condensateur (C2) est disposé de sorte que ladite borne (C21) chevauche la deuxième ligne d'alimentation (12) et que l'autre borne (C22) chevauche la ligne de masse (GND).

2. Dispositif onduleur (1) selon la revendication 1, dans lequel
dans le substrat d'interconnexion (2), des circuits onduleurs (3) de trois phases comprenant chacun la pluralité de transistors (Q1-Q6), le premier condensateur (C1) et le deuxième condensateur (C2) sont agencés dans la première direction (Y), et
une ligne de masse commune (GND) s'étendant dans la première direction (Y) est disposée au-dessus des circuits onduleurs (3) de trois phases, et les lignes de masse (GND) dans les circuits onduleurs (3) de trois phases sont mutuellement connectées par l'intermédiaire de la ligne de masse commune (GND).
